# EUROPEAN PATENT APPLICATION

(11) **EP 4 852 056 A1**
(43) Date of publication of application: **09.12.2026**
(21) Application number: 24922167.2
(22) Date of filing: 02.02.2024
(51) Int. Cl.: H01L 23/12

(54) **LASER PROCESSING DEVICE, LASER MACHINING DEVICE, TRANSFER DEVICE, LASER PROCESSING METHOD, LASER MACHINING METHOD, AND TRANSFER METHOD**

(71) Applicant: Shin-Etsu Engineering Co., Ltd., Tokyo 101-0054 (JP)
(72) Inventor: OHTANI, Yoshikazu, Annaka-shi, Gunma 379-0127 (JP); TOMIOKA, Kyouhei, Annaka-shi, Gunma 379-0127 (JP); SUZUKI, Tomoya, Annaka-shi, Gunma 379-0127 (JP); TAKAHASHI, Hiroshi, Annaka-shi, Gunma 379-0127 (JP); YAMAOKA, Hiroshi, Yokohama-shi, Kanagawa 234-0053 (JP); USAMI, Taketo, Yokohama-shi, Kanagawa 234-0053 (JP); KURATA, Masami, Yokohama-shi, Kanagawa 234-0053 (JP)
(74) Representative: Meissner Bolte Partnerschaft mbB
(86) International application number: PCT/JP2024/003557
(87) International publication number: WO 2025/163908

(57) **Abstract**

The present invention is a laser processing apparatus for performing laser processing by irradiating a substrate arranged on a substrate stage with laser light, the laser processing apparatus comprising: a laser device that oscillates the laser light; a reduced projection optical system; and the substrate stage, and the laser processing apparatus includes a shutter between the reduced projection optical system and the substrate stage. Accordingly, a laser processing apparatus capable of suppressing influence of dimensional change of the reduced projection optical system caused by temperature change of the reduced projection optical system and suppressing a decrease in throughput of the laser processing can be provided.

## Description

### TECHNICAL FIELD

The present invention relates to a laser processing apparatus, a laser machining apparatus, a transfer apparatus, a laser processing method, a laser machining method, and a transfer method.

### BACKGROUND ART

Semiconductor package substrates have been actively developed in line with a trend from "More Than Moore" to a system on a chip (SoC) in which a system is integrated into one chip.

Furthermore, the configurations of semiconductor package substrates have become more complex and denser, and apparatuses using an excimer laser have been applied to manufacturing of base substrates.

For example, Patent Document 1 discloses a laser machining apparatus that emits beam-shaped laser light from a laser oscillator, aligns the directions of principal rays of the laser light by passing the laser light through fθ lens (condenser lens), and performs laser machining on an object to be machined by irradiating the object to be machined with the laser light (pulsed laser light).

### CITATION LIST

### PATENT LITERATURE

Patent Document 1: WO 2013/094025

### SUMMARY OF INVENTION

### TECHNICAL PROBLEM

In the case of a laser processing apparatus and a laser processing method that perform laser processing such as laser machining by irradiating an object to be machined with laser light through a lens, when once laser oscillation of a laser oscillator is turned off during a period in which the laser processing is not performed, and then the laser oscillation is started, time is required for the laser output to stabilize.

It can be expected that stabilized laser output is obtained by providing a shutter attachable to and detachable from a laser light path on a laser incident side of the lens and continuously oscillating laser light. However, another problem occurs that laser output from the lens is not stabilized due to the fact that when the shutter is detached and the laser light path to the lens, which is a reduced projection optical system, is opened, the lens is also subject to laser irradiation and is thus warmed, so dimensional change of the lens continues until the lens is sufficiently warmed and the temperature of the lens no longer changes. For this reason, it has been necessary to wait until dimensional change of the lens ceases and laser output is stabilized. Furthermore, adjustment of the apparatus has sometimes been necessary each time the shutter is opened or closed. As a result, a problem has occurred in that throughput of the laser processing decreases.

The present invention has been made to solve the above-described problems, and an objective of the present invention is to provide a laser processing apparatus and a laser processing method capable of suppressing a decrease in throughput caused by temperature change of a reduced projection optical system in switching between non-irradiation and irradiation with laser light on a substrate that is an object to be processed. Another objective of the present invention is to perform stable processing that is not affected by deformation caused by the temperature of the reduced optical system even when the interval of laser processing changes.

### SOLUTION TO PROBLEM

The present invention has been made to achieve the above-described objectives and provides a laser processing apparatus for performing laser processing by irradiating a substrate arranged on a substrate stage with laser light, the laser processing apparatus comprising a laser device that oscillates the laser light, a reduced projection optical system, and a substrate stage, in which the laser processing apparatus includes a shutter between the reduced projection optical system and the substrate stage.

With such a laser processing apparatus, the reduced projection optical system can be irradiated with the laser light even while the laser light path is blocked by the shutter, and thus the temperature of the reduced projection optical system can be maintained at the same temperature as that during laser processing of a body to be processed, the influence of dimensional change of the reduced projection optical system caused by temperature change can be suppressed, and a decrease in throughput of the laser processing can be suppressed. Moreover, the shape and the position of laser irradiation can be stabilized, and thus stable laser processing can always be performed regardless of the interval of the laser processing.

In the laser processing apparatus, the shutter may be a shutter comprising an optical path changing member that forms an inclined surface with respect to an optical axis of the laser light and is capable of being arranged on the optical axis of the laser light and being removed from the optical axis of the laser light.

Accordingly, the laser light path can be easily blocked and opened.

The laser processing apparatus may further include a damper that, when the shutter blocks an optical axis of the laser light to switch the optical path of the laser light, absorbs energy of the laser light on the switched optical path of the laser light.

Accordingly, safety can be increased, and damage to the apparatus caused by the laser light having the switched optical path can be effectively suppressed.

The above-described laser processing apparatus may be included in a laser machining apparatus, and the laser machining apparatus may perform shape machining on a surface of the substrate by irradiating the substrate with the laser light.

Accordingly, a decrease in throughput of laser machining can be suppressed, and shape machining can be performed on the substrate surface at a stable position and with a stable accuracy.

The above-described laser processing apparatus may be included in a transfer apparatus, and the transfer apparatus may transfer an object to be transferred provided on the substrate to another substrate by irradiating the object to be transferred with the laser light through the substrate.

Accordingly, a decrease in throughput of transfer of the object to be transferred by laser irradiation can be suppressed, and the object to be transferred can be transferred to another substrate reliably and at a stable transfer position.

The present invention also provides a laser processing method for performing laser processing by irradiating a substrate arranged on a substrate stage with laser light by using a laser processing apparatus including a laser device that oscillates the laser light, a reduced projection optical system, the substrate stage, and a shutter between the reduced projection optical system and the substrate stage, and when the substrate is not irradiated with the laser light, the shutter is closed while the laser light is being oscillated.

With such a laser processing method, the reduced projection optical system is irradiated with the laser light even while the laser light path is blocked by the shutter, and thus the temperature of the reduced projection optical system can be maintained at the same temperature as that during laser processing of a body to be processed, the influence of dimensional change of the reduced projection optical system caused by temperature change can be suppressed, and a decrease in throughput of the laser processing can be suppressed.

In the laser processing method, as the shutter, a shutter may be used that comprises an optical path changing member that forms an inclined surface with respect to an optical axis of the laser light and is capable of being arranged on the optical axis of the laser light and being removed from the optical axis of the laser light.

Accordingly, the laser light path can be easily blocked and opened.

In the laser processing method, an optical path of the laser light may be switched by closing the shutter, and energy of the laser light may be absorbed by a damper arranged on the switched optical path of the laser light.

Accordingly, safety can be increased, and damage to the apparatus caused by the laser light having the switched optical path can be effectively suppressed.

The above-described laser processing method may be used in a laser machining method for performing shape machining on a surface of the substrate as the laser processing.

Accordingly, a decrease in throughput of laser machining can be suppressed, and shape machining can be performed on the substrate surface at a stable position and with a stable accuracy.

The above-described laser processing method may be used in a transfer method for transferring an object to be transferred provided on a substrate to another substrate by irradiating the object to be transferred with the laser light through the substrate.

Accordingly, a decrease in throughput of transfer of the object to be transferred by laser irradiation can be suppressed, and the object to be transferred can be transferred to another substrate reliably and at a stable transfer position.

### ADVANTAGEOUS EFFECTS OF INVENTION

As described above, according to a laser processing apparatus of the present invention, a reduced projection optical system is irradiated with laser light, and thus the temperature of the reduced projection optical system can be maintained at the same temperature as that during laser processing of a body to be processed, the influence of dimensional change of the reduced projection optical system caused by temperature change can be suppressed, and a decrease in throughput of the laser processing can be suppressed.

According to a laser machining apparatus of the present invention, a decrease in throughput of shape machining on a substrate surface with laser light can be suppressed, and shape machining can be performed on the substrate surface at a stable position and with a stable accuracy.

According to a transfer apparatus of the present invention, a decrease in throughput of transfer of an object to be transferred by laser irradiation can be suppressed, and the object to be transferred can be transferred to another substrate reliably and at a stable transfer position.

According to a laser processing method of the present invention, a reduced projection optical system is irradiated with laser light even while the laser light path is blocked by a shutter, and thus the temperature of the reduced projection optical system can be maintained at the same temperature as that during laser processing of a body to be processed, the influence of dimensional change of the reduced projection optical system caused by temperature change can be suppressed, and a decrease in throughput of the laser processing can be suppressed.

According to a laser machining method of the present invention, a decrease in throughput of shape machining on a substrate surface with laser light can suppressed, and shape machining can be performed on the substrate surface at a stable position and with a stable accuracy.

According to a transfer method of the present invention, a decrease in throughput of transfer of an object to be transferred by laser irradiation can be suppressed, and the object to be transferred can be transferred to another substrate reliably and at a stable transfer position.

### BRIEF DESCRIPTION OF DRAWINGS

[FIG. 1] is a schematic view illustrating an example of a laser processing apparatus of the present invention;
[FIG. 2] is a schematic view illustrating an example of a laser machining apparatus of the present invention;
[FIG. 3] is a schematic view illustrating an example of laser irradiation in a laser machining method of the present invention;
[FIG. 4] is a schematic view illustrating out-of-focus laser irradiation in FIG. 2;
[FIG. 5] is a schematic view illustrating an example of the laser machining method of the present invention;
[FIG. 6] is a schematic view illustrating another example of laser irradiation in the laser machining method of the present invention;
[FIG. 7] is a schematic sectional view illustrating an example of recessed portions that can be formed by the laser machining method of the present invention;
[FIG. 8] is intensity distribution of an example of laser light that can be used in the laser machining method of the present invention;
[FIG. 9] is a schematic view illustrating a first embodiment of a transfer apparatus (laser lift-off apparatus) of the present invention;
[FIG. 10] is a schematic view illustrating a second embodiment of the transfer apparatus (laser lift-off apparatus) of the present invention; and
[FIG. 11] is a schematic view illustrating a batch transfer process in an example of a transfer method of the present invention.

### DESCRIPTION OF EMBODIMENTS

As described above, there has been a demand for providing a laser processing apparatus and a laser processing method capable of suppressing a decrease in throughput caused by temperature change of a reduced projection optical system in switching between non-irradiation and irradiation with laser light on a substrate that is an object to be processed, and capable of suppressing changes in processing position and processing accuracy.

As a result of extensive studies on the above-described problems, the inventors found that, in a laser processing apparatus, providing a shutter between a reduced projection optical system and a substrate stage allows laser light to be incident on the reduced projection optical system even when laser processing is not performed on a substrate, thereby making it possible to suppress temperature change of the reduced projection optical system, and by extension, suppress a decrease in throughput of the laser processing and changes in processing position and processing accuracy, which has led to completion of the present invention.

Specifically, the present invention is a laser processing apparatus for performing laser processing by irradiating a substrate arranged on a substrate stage with laser light, the laser processing apparatus including a laser device that oscillates the laser light, a reduced projection optical system, and the substrate stage, and the laser processing apparatus includes a shutter between the reduced projection optical system and the substrate stage.

The present invention is also a laser machining apparatus including the above-described laser processing apparatus, and the laser machining apparatus performs shape machining on a surface of the substrate by irradiating the substrate with the laser light.

The present invention is also a transfer apparatus including the above-described laser processing apparatus, and the transfer apparatus transfers an object to be transferred provided on the substrate to another substrate by irradiating the object to be transferred with the laser light through the substrate.

The present invention is also a laser processing method for performing laser processing by irradiating a substrate arranged on a substrate stage with laser light by using a laser processing apparatus including a laser device that oscillates the laser light, a reduced projection optical system, the substrate stage, and a shutter between the reduced projection optical system and the substrate stage, and when the substrate is not irradiated with the laser light, the shutter is closed while the laser light is being oscillated.

The present invention is also a laser machining method for performing shape machining on a surface of the substrate as the laser processing by using the above-described laser processing method.

The present invention is also a transfer method for transferring an object to be transferred provided on a substrate to another substrate by irradiating the object to be transferred with the laser light through the substrate, by using the above-described laser processing method.

The present invention will be described below in detail, but the present invention is not limited to these descriptions.

### [Laser Processing Apparatus]

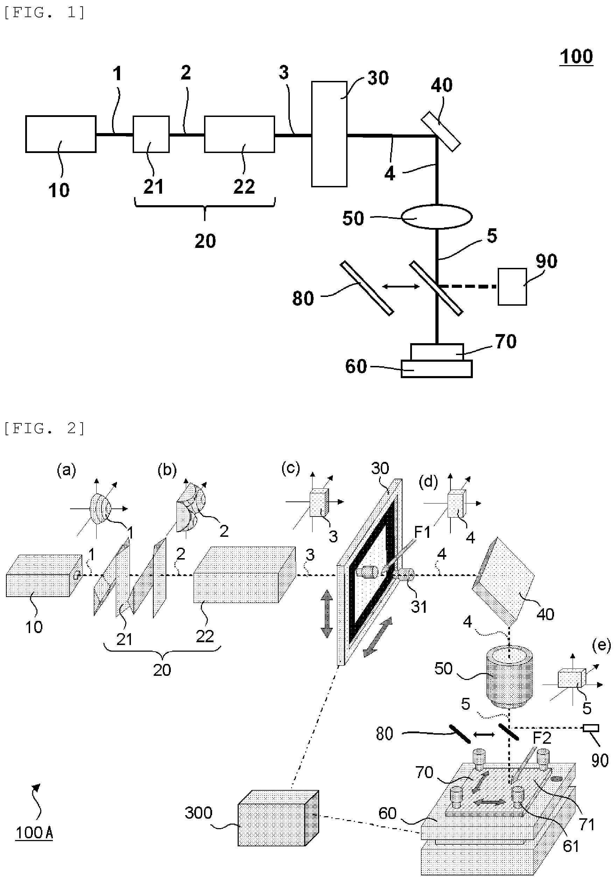

FIG. 1 is a schematic view illustrating an example of a laser processing apparatus of the present invention. As illustrated in FIG. 1, a laser processing apparatus 100 according to the present invention is a laser processing apparatus 100 that includes a laser device 10 including a laser light source that oscillates laser light 1, a reduced projection optical system 50, and a substrate stage 60, and performs laser processing by irradiating a substrate 70 arranged on the substrate stage 60 with laser light 5. The laser processing apparatus 100 includes a shutter 80 between the reduced projection optical system 50 and the substrate stage 60.

With the laser processing apparatus of the present invention including the shutter 80 on the substrate stage 60 side relative to the reduced projection optical system 50 in this manner, the laser light can be maintained in a state of having reached the reduced projection optical system 50 even when the shutter is closed and laser processing is not performed on the substrate 70, and thus the temperature of the reduced projection optical system 50 can be maintained at the same temperature as that during laser processing of the substrate 70. Accordingly, the influence of dimensional change of the reduced projection optical system 50 caused by temperature change of the reduced projection optical system 50 can be suppressed, a decrease in throughput of the laser processing can be suppressed, and a processing position and processing accuracy can be stabilized.

The shutter 80 is not particularly limited as long as the shutter 80 is capable of blocking and opening laser light 5 that has passed through the reduced projection optical system 50. For example, the shutter 80 is preferably a shutter comprising an optical path changing member that forms an inclined surface with respect to an optical axis of the laser light and is capable of being arranged on the optical axis of the laser light and being removed from the optical axis of the laser light. With such a shutter, the laser light path can be easily blocked and opened. Note that means for arranging the optical path changing member on the optical axis of the laser light and removing the optical path changing member from the optical axis of the laser light is not limited, and may be means for linearly moving the optical path changing member, positioning the optical path changing member on the optical axis of the laser light, and blocking the laser light path, or may be means for blocking the laser light path by changing the angle of the shutter in a shutter (optical path changing member) unit provided between the reduced projection optical system 50 and the substrate stage 60.

In addition, as illustrated in FIG. 1, the laser processing apparatus 100 more preferably includes a damper 90 that, when the shutter 80 blocks an optical axis of the laser light to switch the optical path of the laser light, absorbs energy of the laser light on the switched optical path of the laser light. Accordingly, safety can be increased, and damage to the apparatus caused by the laser light having the switched optical path can be effectively suppressed.

### (Laser Device)

The laser device 10 that oscillates laser light 1 is not particularly limited, and may be, for example, a laser device (laser oscillator) that performs irradiation with (emits) laser light 1 in pulses. More specifically, the laser device 10 illustrated in FIG. 1 may include an excimer laser oscillator. Use of an excimer laser enables high-productivity processing. In addition, since the excimer laser has low coherence, use of the excimer laser can achieve extremely uniform beam formation.

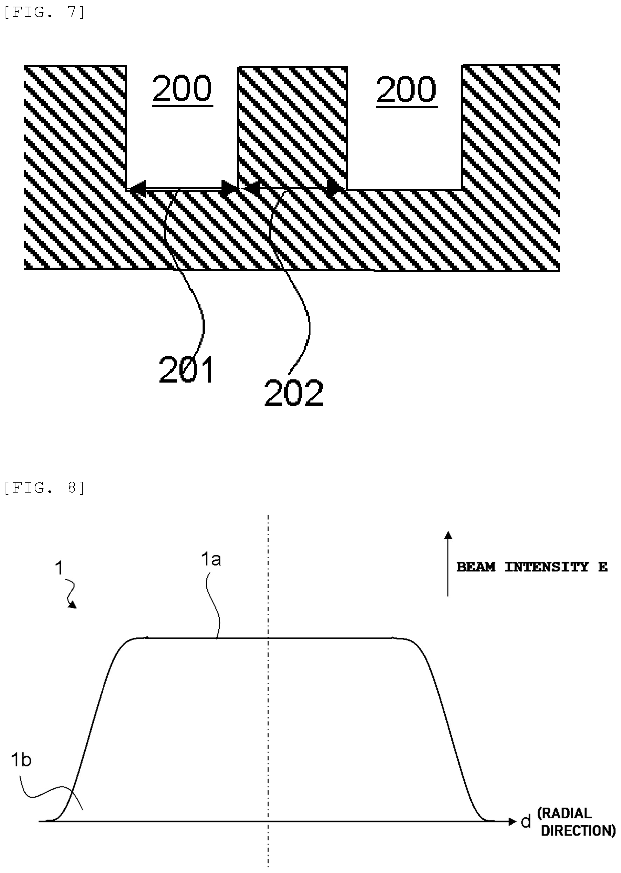

Note that the irradiation shape of laser light 1 oscillated by the laser device 10 is not particularly limited. For example, as in an irradiation shape illustrated in FIG. 8, the irradiation shape may have an intensity distribution in which laser intensity of a center (inner side) 1a is highest and laser intensity of a skirt (outer side) 1b is low.

### (Reduced Projection Optical System)

In the laser processing apparatus 100 illustrated in FIG. 1, inclusion of the reduced projection optical system 50 makes it possible to enlarge a mask pattern formed on a photomask 30 relative to a processing pattern to be actually processed on an object to be processed.

By enlarging the mask pattern formed on the photomask 30 relative to the actual processing pattern, energy of laser light 3 incident on the photomask 30 can be made smaller than actual processing energy. When the reduction magnification of the reduced projection optical system 50 is defined as N, energy of laser light incident on a mask surface is 1/(N²) relative to machining energy on a surface of the substrate 70. Accordingly, thermal drift caused by energy of laser light 3 can be suppressed, and thus thermal expansion of the photomask 30 can be suppressed, and high-accuracy processing can be performed even after processing operation for a long time.

In addition, degradation of optical members (for example, an optical system 20 and the photomask 30) caused by heat of laser light can also be prevented, and thus the lifetime of the optical members can be extended.

The reduced projection optical system 50 may include a pair of reduced projection lenses. When the reduced projection optical system 50 is an infinity optical system, magnification by the reduced projection optical system 50 can be adjusted by, for example, the ratio of the focal lengths of the reduced projection lenses and the distance between the reduced projection lenses.

The NA of the reduced projection lenses is preferably selected in accordance with energy density necessary for machining the substrate 70 and the resolution of processing. The NA of the reduced projection lenses is preferably 0.12 or more. In the present invention, even when laser processing is performed with a high NA for formation at high resolution, a recessed portion and/or a through-hole to be formed can be suppressed from having a tapered shape.

The laser processing apparatus 100 of the present invention preferably further includes a temperature adjustment means that adjusts the temperature of the reduced projection optical system 50.

Inclusion of the temperature adjustment means can further prevent the influence of heat due to laser energy in the reduced projection optical system 50. As described above, in the reduced projection optical system 50, laser light 4 that has passed through the photomask 30 is reduced and projected at 1/N, and accordingly, energy of laser light passing through a lens portion at an objective distal end is N² times energy of laser light with which the photomask 30 is irradiated, and thermal influence tends to occur in this portion. Thus, in order to suppress this thermal energy, a temperature adjustment function is provided to the reduced projection optical system 50, and thus thermal drift caused by energy of laser light can be suppressed, and high-accuracy processing can be performed even after machining operation for a long time.

In the laser processing method and the laser processing apparatus 100 of the present invention, a reduced projection lens having an extremely small aperture can be used by operating the photomask 30 and the substrate stage 60 in synchronization and fixing the position of laser beam during processing of a substrate. Temperature adjustment means for a reduced projection lens cannot directly provide the temperature adjustment means to the lens but cools a jacket portion holding the lens, and thus when the lens aperture is large, temperature can be managed in a peripheral portion of the lens, but a temperature adjustment effect is unlikely to reach the vicinity of an important central portion, and thermal management is difficult. For this reason, even slight energy absorption into the lens due to laser irradiation for a long time easily causes thermal distortion. When the laser processing apparatus 100 has a temperature adjustment function for the reduced projection optical system 50, the lens aperture can be reduced, and thus such defect can be suppressed.

In addition, defects caused by laser irradiation of the reduced projection optical system 50 can be suppressed to extend lifetime.

### (Optical System)

As illustrated in FIG. 1, the laser processing apparatus 100 according to the present invention may include the optical system 20 that shapes the irradiation shape of laser light 1. In the example of the laser machining apparatus 100 illustrated in FIG. 1, the optical system 20 may include a prism 21 that changes the irradiation shape of intensity distribution of laser light 1, and a shaping optical system 22 that further shapes the irradiation shape of laser light 2 from the prism 21.

The photomask 30 that forms laser light 3 shaped by the optical system 20 into a desired pattern, a folding mirror 40 that changes the optical axis of laser light 4 from the photomask 30, and the like may be further included. Shaping of the irradiation shape of laser light by the optical system 20 and the photomask 30 will be described in detail in description of laser machining.

Note that the optical system 20, the photomask 30, and the folding mirror 40 are optional members for the laser machining apparatus 100 of the present invention.

In addition, the laser processing apparatus 100 may further include a controller that controls each component or the entirety of the apparatus. In particular, the controller may be capable of performing control to implement the laser processing method to be described later. Note that the laser processing apparatus 100 illustrated in FIG. 1 is an example of the laser processing apparatus of the present invention, but the laser processing apparatus of the present invention is not limited to the apparatus illustrated in FIG. 1.

### [Laser Processing Method]

The laser processing method according to the present invention is characterized in that, in a laser processing method for performing laser processing by irradiating the substrate 70 arranged on the substrate stage 60 with laser light by using the laser processing apparatus 100 including the laser device 10 that oscillates the laser light, the reduced projection optical system 50, the substrate stage 60, and the shutter 80 between the reduced projection optical system 50 and the substrate stage 60, as illustrated in FIG. 1, when the substrate 70 is not irradiated with the laser light, the shutter 80 is closed while the laser light is being oscillated.

According to the laser processing method of the present invention, when laser processing is not performed on a substrate, the shutter is closed and laser light can be maintained in a state of having reached the reduced projection optical system 50, and thus the temperature of the reduced projection optical system 50 can be maintained at the same temperature as that during laser processing of the substrate 70. Since the influence of dimensional change of the reduced projection optical system 50 caused by temperature change of the reduced projection optical system 50 can be suppressed, it is possible, when laser processing of the substrate 70 is to be resumed, to resume the laser processing only by removing the shutter from the optical path, and a decrease in throughput of the laser processing can be suppressed. Moreover, the shape and the position of laser irradiation can be stabilized, and thus stable laser processing can always be performed regardless of the interval of laser processing.

In addition, as the shutter 80, a shutter is preferably used that comprises an optical path changing member that forms an inclined surface with respect to an optical axis of the laser light and capable of being arranged on the optical axis of the laser light and being removed from the optical axis of the laser light. In this manner, the laser light path can be easily blocked and opened.

In addition, the optical path of laser light is preferably switched by closing the shutter 80 so that energy of the laser light is absorbed by the damper 90 arranged on the switched optical path of the laser light. In this manner, safety can be increased, and damage to the apparatus caused by the laser light having the switched optical path can be effectively suppressed.

### [Laser Machining Apparatus]

The laser processing apparatus according to the present invention may be a laser machining apparatus that performs shape machining on a surface of the substrate by irradiating the substrate with laser light. Examples of the shape machining on the surface of the substrate include machining for forming a recessed portion or a through-hole on the substrate surface. Specific examples include wiring-groove forming machining and VIA-hole forming machining on a surface of a substrate used for a semiconductor package substrate. In the following description, description of configurations similar to those of the above-described laser processing apparatus may be omitted.

A specific form of the laser machining apparatus according to the present invention is illustrated in FIG. 2. As illustrated in FIG. 2, a laser machining apparatus 100A according to the present invention includes the shutter 80 on the substrate stage 60 side relative to the reduced projection optical system 50. With such a laser machining apparatus according to the present invention, when laser machining is not performed on a substrate, the shutter is closed and laser light can be maintained in a state of having reached the reduced projection optical system 50, and thus the temperature of the reduced projection optical system 50 can be maintained at the same temperature as that during laser machining of the substrate. It is possible, when laser machining of the substrate is to be resumed, to resume the laser machining only by removing the shutter from the optical path. The influence of a positional accuracy change and a dimensional change of the reduced projection optical system 50 caused by temperature change of the reduced projection optical system 50 can be suppressed, and a decrease in throughput of laser machining can be suppressed.

### (Laser Device)

Laser light 1 is not particularly limited, and for example, an excimer laser may be used. Use of the excimer laser enables efficient machining of an object to be machined that is made of an organic material, such as an ABF substrate, and enables high-productivity machining. In addition, since the excimer laser has low coherence, use of the excimer laser can achieve extremely uniform beam formation.

In addition, use of the excimer laser enables adjustment of machining depth with higher accuracy and adjustment of the width of a recessed portion and/or a through-hole with higher accuracy than use of a solid laser. In particular, the excimer laser is useful for forming recessed portions such as blind holes and trenches. Thus, use of the excimer laser enables high-accuracy machining of a complex protrusion-recess shape such as a circuit board.

Note that the irradiation shape of laser light 1 oscillated by the laser device 10 is not particularly limited. For example, as in the irradiation shape illustrated in FIG. 8, the irradiation shape may have an intensity distribution in which laser intensity of the center (inner side) 1a is highest and laser intensity of the skirt (outer side) 1b is low.

### (Reduced Projection Optical System)

In the laser machining apparatus 100A illustrated in FIG. 2, inclusion of the reduced projection optical system 50 enlarges a mask pattern formed on the photomask 30 relative to a machining pattern to be actually formed on an object to be machined. The reduced projection optical system of the laser machining apparatus 100A is similar to the reduced projection optical system described above for the laser processing apparatus.

### (Optical System)

As illustrated in FIG. 2, the laser machining apparatus 100A according to the present invention may include the optical system 20 that makes the irradiation shape of laser light 1 into an irradiation shape in which, in intensity distribution of laser light on a surface to be machined of the substrate 70, the intensity of an outer portion of the intensity distribution is higher than the intensity of an inner portion of the intensity distribution. In the example of the laser machining apparatus 100A illustrated in FIG. 2, the optical system 20 may include the prism 21 and the shaping optical system 22. Although details will be described below, the prism 21 is a prism that converts laser light having an intensity distribution in which the laser intensity at the center is highest and the laser intensity at the skirt is low into laser light having an irradiation shape in which the intensity of an outer portion in the intensity distribution of the laser light is higher than the intensity of an inner portion, and the shaping optical system 22 is a shaping optical system that converts the irradiation shape of the laser light converted by the prism 21 into a top-hat irradiation shape. In the laser machining apparatus 100A illustrated in FIG. 2, the prism 21 includes a roof prism, but may have a conical prism.

The laser machining apparatus 100A illustrated in FIG. 2 may further include the photomask 30 and the folding mirror 40 in the stated order from the optical system 20 to the substrate 70 in the optical path of the laser machining apparatus 100A. In addition, the laser machining apparatus 100A may further include a controller that controls each component or the entirety of the apparatus.

Note that the optical system 20, the photomask 30, the folding mirror 40, and a controller 300 are optional members for the laser machining apparatus 100A of the present invention.

As illustrated in FIG. 2, the laser machining apparatus 100A may include a mask alignment camera 31 as image capturing means for reading a feature portion of the photomask 30, and an object-to-be-machined alignment camera 61 as image capturing means for reading a feature portion of the substrate 70. The mask alignment camera 31 is configured to send position information of the feature portion of the photomask 30 to the controller 300. The object-to-be-machined alignment camera 61 is configured to send position information of the feature portion of the substrate 70 to the controller 300. The controller 300 is configured to align the relative positions of the substrate 70 and the photomask 30 based on the position information. In another aspect, the controller 300 may be configured to move the substrate 70 placed on the stage 60 and the photomask 30 in synchronization.

### [Laser Machining Method]

The laser machining method of the present invention can be performed by using, for example, the laser machining apparatus of the present invention, but may also be performed by using an apparatus other than the laser machining apparatus of the present invention.

The laser machining method of the present invention is a laser machining method for performing shape machining on a surface of the substrate 70 by using laser light. Examples of the shape machining on the surface of the substrate include machining for forming a recessed portion or a through-hole on the substrate surface. Specific examples include wiring-groove forming machining and VIA-hole forming machining on a surface of a substrate used for a semiconductor package substrate.

According to the laser machining method of the present invention, when laser machining is not performed on a substrate, the shutter is closed and laser light can be maintained in a state of having reached the reduced projection optical system 50, and thus the temperature of the reduced projection optical system 50 can be maintained at the same temperature as that during laser processing of the substrate. Since the influence of dimensional change of the reduced projection optical system 50 caused by temperature change of the reduced projection optical system 50 can be suppressed, laser machining of the substrate can be resumed only by removing the shutter from the optical path, and a decrease in throughput of laser machining can be suppressed. Moreover, the shape and the position of laser irradiation can be stabilized, and thus stable machining processing can always be performed regardless of the interval of laser machining.

Hereinafter, an embodiment of the laser machining method of the present invention that can be performed by using the laser machining apparatus 100A illustrated in FIG. 2 will be specifically described.

Optional matters of the laser machining method and the laser machining apparatus of the present invention will be described below, but the present invention is not limited to examples described below.

The substrate 70, which is an object to be subject to laser machining in the present invention, is not particularly limited, and for example, a semiconductor package substrate may be used as the substrate 70.

In laser machining according to the embodiment of the present invention, machining can be performed with the intensity distribution of laser light on a surface to be machined of the substrate 70 being an irradiation shape in which the intensity of the outer portion of the intensity distribution is higher than the intensity of the inner portion of the intensity distribution. Such a laser machining method will be described by way of example with reference to FIGS. 2 to 5.

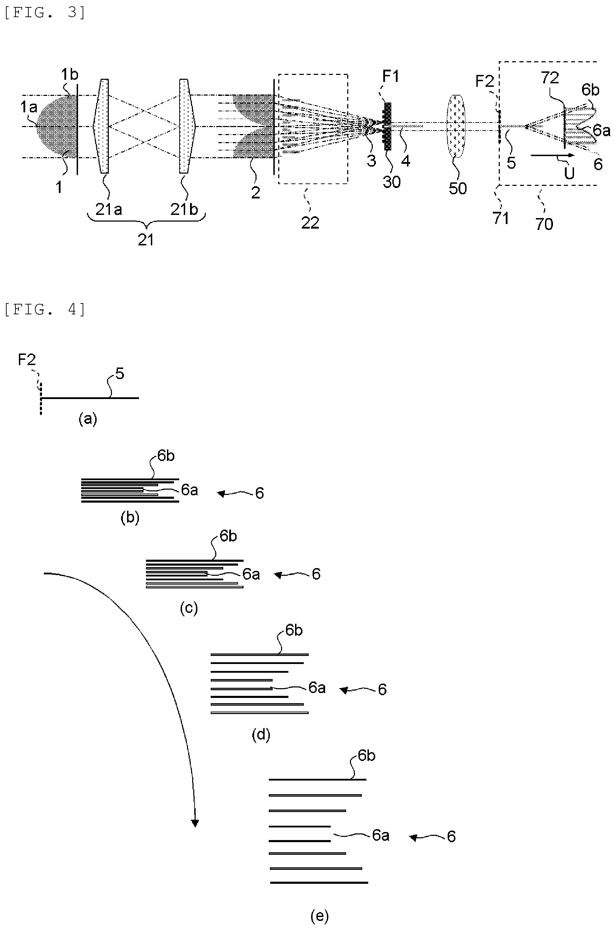

First, as illustrated in FIG. 2, the laser device 10 oscillates laser light 1 having an irradiation shape illustrated in FIG. 2(a). As illustrated in FIG. 3, the irradiation shape of laser light 1 in this example is the irradiation shape of laser light in which the laser intensity of an inner portion 1a is higher than the laser intensity of an outer portion 1b. In another aspect, the irradiation shape of laser light 1 has an intensity distribution in which the laser intensity of the center (inner side) 1a is highest and the laser intensity of the skirt (outer side) 1b is low.

Subsequently, laser light 1 is incident on the prism 21 of the optical system 20. The prism 21 is a prism that converts laser light 1 into laser light 2 having an irradiation shape (FIG. 2(b)) in which the intensity of an outer portion in the intensity distribution of laser light 1 is higher than the intensity of an inner portion. In FIG. 2, the prism 21 including four (two pairs) of roof prisms is illustrated as an example of the prism 21. Note that, in FIG. 3, only two roof prisms 21a and 21b related to the irradiation shape of laser light 1 along a plane parallel to the sheet are representatively illustrated.

The prism 21 is not limited to roof prisms and may be, for example, a prism including conical prisms.

Subsequently, laser light 2 emitted from the prism 21 and having the irradiation shape illustrated in FIGS. 2(b) and 3 is incident on the shaping optical system 22. As illustrated in FIG. 3, the shaping optical system 22 condenses each component of laser light 2 toward an image formation point F1, shapes the irradiation shape of laser light 2 into the top-hat irradiation shape illustrated in FIG. 2(c), and forms laser light 3.

Laser light 3 is incident on the photomask 30 located at the position of the image formation point F1. The photomask 30 has a mask pattern corresponding to a pattern to be machined on the substrate 70. A recessed portion and/or a through-hole can be formed in the substrate 70 in a desired pattern by performing scanning irradiation with the laser light on the substrate 70 through the photomask 30.

Laser light 4 emitted from the photomask 30 and having the irradiation shape (top-hat shape) illustrated in FIG. 2(d) has a direction converted by the folding mirror 40 and is incident on the reduced projection optical system (projection lens) 50. Effects obtained by using the reduced projection optical system 50 will be described later.

As illustrated in FIG. 3, laser light 5 emitted from the reduced projection optical system 50 reaches a surface (initial surface to be machined) 71 of the substrate 70. FIG. 3 illustrates an example in which an image formation point F2 of the reduced projection optical system 50 is aligned with the surface 71 of the substrate 70. However, the image formation point F2 of the reduced projection optical system 50 is not limited to the surface 71 of the substrate 70.

As illustrated in FIG. 3, the irradiation shape of laser light 5 with which the surface 71 of the substrate 70 is irradiated is a top-hat type as illustrated in FIG. 2(e). On the other hand, on a surface to be machined 72 on which machining has progressed further from the image formation point F2, as illustrated in FIG. 3, machining is performed with the intensity distribution of laser light 6 being an irradiation shape in which the intensity of an outer portion 6b of the intensity distribution is higher than the intensity of an inner portion 6a.

In the examples illustrated in FIGS. 2 and 3, as schematically illustrated in FIGS. 4(a) to 4(e), the irradiation shape of laser light 6 becomes closer to the irradiation shape of laser light 2 before shaping by the shaping optical system 22 as the position becomes farther from the image formation point F2 (under-focus U). This is the reason why the intensity distribution of laser light 6 is such that the intensity of the outer portion 6b of the intensity distribution is higher than the intensity of the inner portion 6a.

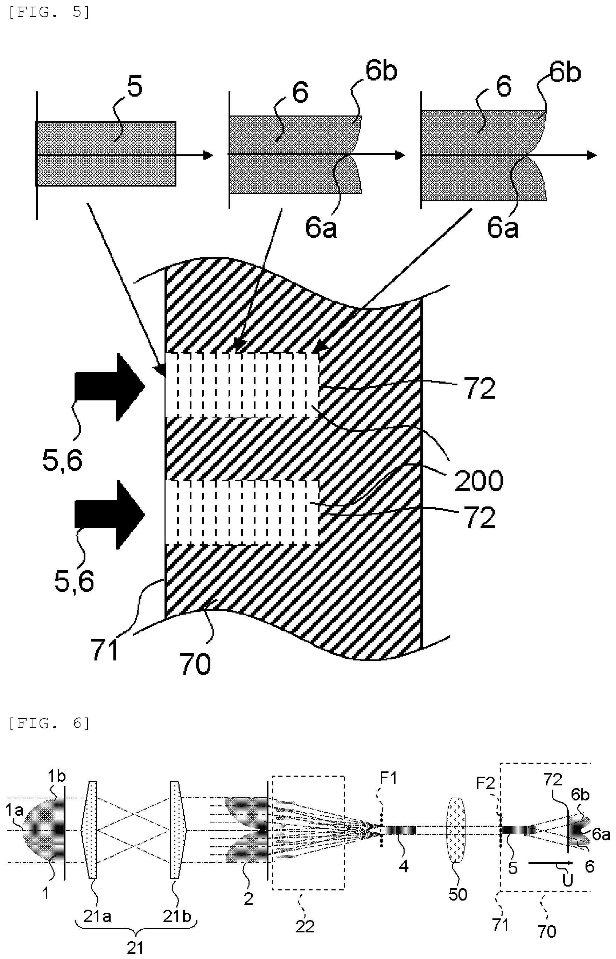

On the surface to be machined 72, machining is performed with the intensity distribution of laser light 6 being an irradiation shape in which the intensity of the outer portion 6b of the intensity distribution is higher than the intensity of the inner portion 6a, thereby making it possible to suppress a recessed portion 200 to be formed from having a tapered shape as schematically illustrated in FIG. 5. By continuing the machining, a through-hole in which tapering is suppressed can be formed. Moreover, in the laser machining method of the present embodiment, since a recessed portion and/or a through-hole formed in this manner can be suppressed from having a tapered shape, a high-definition and complex pattern can be formed. In addition, according to the laser machining method of the present embodiment, even when a recessed portion and/or a through-hole is formed at high resolution, the recessed portion 200 and/or through-hole to be formed can be suppressed from having a tapered shape.

In the laser machining method of the present embodiment, machining can be performed on at least part of the surface to be machined 72 of the substrate 70 with laser light having an irradiation shape in which the intensity of the outer portion 6b is higher than the intensity of the inner portion 6a. For example, as in the examples illustrated in FIGS. 2 and 3, machining may be performed on the surface (initial surface to be machined) 71 of the substrate 70 with laser light 5 having a top-hat irradiation shape.

In the present embodiment, for example, as illustrated in FIG. 5, machining can be performed while changing the shape of the intensity distribution of laser light 6 on the surface to be machined 72 of the substrate 70 as machining proceeds in the depth direction of the substrate 70.

The example illustrated in FIG. 5 can also be regarded, in another aspect, as an example in which machining is performed while the shape of the intensity distribution of laser light 6 is changed such that the intensity of the outer portion 6b in the intensity distribution of laser light 6 becomes higher than the intensity of the inner portion 6a as machining proceeds in the depth direction of the substrate 70.

By performing machining in this manner, a recessed portion and/or a through-hole to be formed can be more reliably suppressed from having a tapered shape, and by extension, a high-definition and complex pattern can be more reliably formed.

However, in the present embodiment, machining only needs to be performed with the intensity distribution of laser light 6 on at least one surface to be machined 72 of the substrate 70 being an irradiation shape in which the intensity of the outer portion 6a of the intensity distribution is higher than the intensity of the inner portion 6b, and the laser intensity distribution does not need to be continuously changed.

In the present invention, the photomask 30 may be used to form a predetermined recessed portion and/or through-hole with patterning. Even when the photomask 30 is used, a recessed portion and/or a through-hole to be formed can be suppressed from having a tapered shape by performing machining with the intensity distribution of laser light 6 on the surface to be machined 72 of the substrate 70 being an irradiation shape in which the intensity of the outer portion 6b of the intensity distribution is higher than the intensity of the inner portion 6a, and by extension, a high-definition and complex pattern can be reliably formed. Alternatively, as illustrated in FIG. 6, the photomask 30 does not need to be used in the present invention.

The embodiment of the present invention described above with reference to FIGS. 2 to 5 can be regarded, in another aspect, as a laser machining method for forming a recessed portion and/or a through-hole in the substrate 70 by using laser light, the laser machining method using the optical system 20 that shapes the irradiation shape of laser light 2, which is a shape in which the intensity of an outer portion in the intensity distribution of the laser light is higher than the intensity of an inner portion, into a top-hat irradiation shape.

By laser-machining the substrate 70 by using such an optical system 20, machining in at least part of the substrate 70 away from the surface can be performed with the irradiation shape of laser light 6, which is a shape in which the intensity of the outer portion 6b is higher than the intensity of the inner portion 6a. With such a laser machining method, even when a recessed portion is formed at high resolution, the width of a bottom portion of the recessed portion can be suppressed from becoming smaller than the width of an opening portion of the recessed portion at the initial machining surface 71. In addition, with such a laser machining method, even when a through-hole is formed at high resolution, the width of a lower-end opening portion of the through-hole can be suppressed from becoming smaller than the width of an upper end portion of the through-hole. In other words, in the laser machining method of the present embodiment expressed in this aspect, even when a recessed portion and/or a through-hole is formed at high resolution, the recessed portion and/or the through-hole to be formed can be suppressed from having a tapered shape, and by extension, a high-definition and complex pattern can be formed.

Particularly in machining of a semiconductor package substrate, there is a machining pattern in which through-holes and recessed portions, for example, VIA machining and groove machining, are mixed. In this case, machining can be performed in the same process by the method of the present embodiment without separating the processes of VIA machining and groove machining. In addition, semiconductor package substrates have become denser, and in a conventional laser drilling method in VIA machining, machining time increases due to an increase in the number of holes to be machined along with densification, but the present method does not cause an increase in machining time due to an increase in the number of holes to be machined and an increase in pattern definition.

According to another embodiment of the laser machining method of the present invention, for example, ablation machining may be performed on the substrate 70. In ablation machining, laser settings can be freely made within wavelengths and energy densities at which ablation machining can be performed, as long as the substrate 70 absorbs energy from laser light 5 and 6.

As described above, according to the embodiment of the present invention, a high-definition pattern of a recessed portion and/or a through-hole can be formed. Specifically, according to the embodiment of the present invention, for example, a recessed portion and/or a through-hole having a width of 20 µm or less and having suppressed tapering can be formed.

In addition, a recessed portion and/or a through-hole that can be formed in the embodiment of the present invention may have, for example, a depth of 20 µm or less. Note that a recessed portion can be formed when the machining depth is less than the thickness of the substrate 70, and a through-hole can be formed when the machining depth is the same as the thickness of the substrate 70.

In another aspect, according to the embodiment of the present invention, a pattern of a recessed portion and/or a through-hole having a high aspect ratio can be formed. According to the embodiment of the present invention, for example, a recessed portion in which the ratio of the height of a machined portion to the width of a bottom portion of the recessed portion is 1.0 or more can be formed. In addition, according to the present invention, for example, a recessed portion in which the ratio of the height of a machined portion to the width of a lower-end opening portion of a through-hole is 1.0 or more can be formed.

In still another aspect, according to the embodiment of the present invention, for example, a recessed portion in which the width of a bottom portion of the recessed portion is 70% or more of the opening width of the recessed portion at an initial machining surface of an object to be machined, and/or a through-hole in which the width of a lower-end opening portion of the through-hole is 70% or more of the width of an upper-end opening portion of the through-hole at an initial machining surface of an object to be machined can be formed.

Moreover, in the embodiment of the present invention, since a recessed portion can be formed while tapering is suppressed, a plurality of recessed portions 200 can be formed as illustrated in FIG. 7, and a distance 202 between bottom portions of adjacent recessed portions 200 can be 110% or less of a width 201 of the bottom portion. Thus, in the embodiment of the present invention, the plurality of recessed portions 200 can be formed at high density.

### <Scanning Irradiation>

In the present invention, machining may be performed while laser light 5 and 6 is scanned relative to a surface to be machined 71. In other words, laser machining of the present invention may be scanning machining.

By performing scanning machining, laser machining can be performed with high accuracy even on a large-area substrate 70.

In addition, by performing scanning machining, an increase in machining time can be prevented even when the density of a recessed portion and/or a through-hole to be machined increases.

Scanning machining can be performed by, for example, moving the substrate 70 placed on the stage 60 and the photomask 30 in synchronization.

In this manner, laser machining can be performed without moving laser light 1 to 6.

In addition, in this aspect, since a machining region is not limited to an area of a lens, an area (angle of view) larger than the area of the lens can be machined.

According to this aspect, the reduced projection optical system 50 necessary for irradiation can be made small, and laser irradiation positional accuracy and temperature controllability can also be improved. Moreover, since the reduced projection optical system 50 described below can be made small, image distortion caused by irradiation is also small.

In the laser machining apparatus 100A illustrated in FIG. 2, the substrate 70 placed on the stage 60 and the photomask 30 can be moved in synchronization by using the controller 300.

More specifically, the controller 300 is configured to align the relative positions of the substrate 70 and the photomask 30 based on position information of the feature portion of the mask 30 acquired by the mask alignment camera 31 and position information of the feature portion of the substrate 70 acquired by the object-to-be-machined alignment camera 61.

### [Transfer Apparatus]

The transfer apparatus according to the present invention may be an apparatus that irradiates the interface between an object to be transferred and a substrate (first substrate) including the object to be transferred with laser light, thereby peeling the object to be transferred from the first substrate (Laser Lift-OFF (LLO)), and transfers the peeled object to be transferred to another substrate (second substrate). Note that, as the laser lift-off method, so-called gap laser lift-off (Gap-LLO) and contact laser lift-off (Contact-LLO) are known.

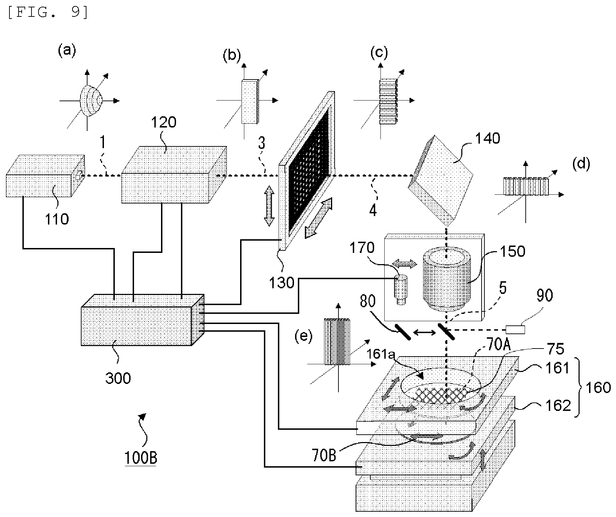

FIG. 9 schematically illustrates an embodiment of the transfer apparatus of the present invention. A transfer apparatus 100B illustrated in FIG. 9 is an apparatus configured to perform Gap-LLO. The transfer apparatus 100B includes a laser device (laser oscillator) 110, a substrate stage 160, a reduced projection optical system 150, and the shutter 80 between the reduced projection optical system 150 and the substrate stage 160.

In the transfer apparatus of the present invention, when transfer of an object to be transferred is not performed, the shutter is closed and laser light can be maintained in a state of having reached the reduced projection optical system 150, and thus the temperature of the reduced projection optical system 150 can be maintained at the same temperature as that during transfer of the object to be transferred. Since the influence of dimensional change of the reduced projection optical system 150 caused by temperature change of the reduced projection optical system 150 can be suppressed, transfer of the object to be transferred can be resumed only by removing the shutter from the optical path when laser machining of the substrate is resumed, and a decrease in throughput of transfer of the object to be transferred can be suppressed.

The transfer apparatus 100B further includes, as optional components, a shaping optical system 120, a photomask 130, a folding mirror 140, an alignment camera 170, and the controller 300. Hereinafter, description of configurations common to the above-described laser processing apparatus and laser machining apparatus may be omitted.

The substrate stage 160 is constituted by an upper stage 161 that has an opening portion 161a and supports a first substrate 70A, and a lower stage 162 that supports a second substrate 70B. The first substrate 70A may include a plurality of objects to be transferred 75. The substrate stage 160 may be configured to support the first substrate 70A and the second substrate 70B such that the first substrate 70A and the second substrate 70B face each other.

A laser device 110 is configured to oscillate laser light 1. In the transfer apparatus 100B, members are arranged so as to form an optical path in which laser light 1 oscillated from the laser device 110 is shaped into laser light 3 through the shaping optical system 120, laser light 3 is shaped into laser light 4 through the photomask 130, laser light 4 has a traveling direction changed by the folding mirror 140 and further becomes laser light 5 through the reduced projection optical system 150, and laser light 5 passes through the opening portion 161a of the upper stage 161 and reaches the first substrate 70A. In other words, the photomask 130 is arranged in the optical path between the laser device 110 and the substrate stage 160.

In addition, in the transfer apparatus 100B illustrated in FIG. 9, the laser device 110, the photomask 130, and the substrate stage 160 (the upper stage 161 and the lower stage 162) are configured to collectively irradiate the interfaces between the plurality of objects to be transferred 75 and the first substrate 70A with laser light from the laser device 110.

Hereinafter, laser light oscillated from the laser device 110 and its optical path will be described.

Laser light 1 oscillated from the laser device 110 may be, for example, an excimer laser.

An optional shaping optical system 120 shapes the irradiation shape of laser light 1 oscillated from the laser device 110, which is illustrated in FIG. 9(a), for example, into a rectangular irradiation shape illustrated in FIG. 9(b), for example, and emits the shaped laser light 1 as laser light 3. Laser light 3 having the rectangular irradiation shape can exhibit uniform irradiation energy density, and has, for example, a beam profile exhibiting a top-hat shape. However, laser shaping by the shaping optical system 120 is not limited thereto.

The photomask 130 is configured to shape the irradiation shape of incident laser light 3 into a pattern shape as illustrated in FIG. 9(c) and emit the shaped laser light 3 as laser light 4. More specifically, the photomask 130 has a pattern that shapes laser light from the laser device 110 into a shape for irradiating only part of the interface between each of the plurality of objects to be transferred 75 and the first substrate 70A. The photomask 130 is also configured to collectively irradiate the interface between each of the plurality of objects to be transferred 75 and the first substrate 70A with received laser light, and can also be regarded as having a pattern that shapes laser light such that only part of the interface between each of the plurality of objects to be transferred 75 and the first substrate 70A serves as an irradiation region.

The photomask 130 may further have a pattern that shapes laser light into a shape for irradiating the entirety of the interface between each of the plurality of objects to be transferred 75 and the first substrate 70A. Other details of the photomask 130 will be described later.

Laser light 4 emitted from the photomask 130 has a traveling direction changed by the folding mirror 140 and is incident on the reduced projection optical system 150. The reduced projection optical system 150 reduces the irradiation shape of incident laser light 4 from, for example, the shape illustrated in FIG. 9(d) to the shape illustrated in FIG. 9(e), and emits the reduced laser light 4 as laser light 5.

When the reduced projection optical system 150 is incorporated into the optical path, energy of laser light 20b incident on the photomask 130 can be made smaller than energy necessary for peeling the object to be transferred 75 from the first substrate 70A. When the reduction magnification of the reduced projection optical system 150 is defined as N, energy of laser light 3 incident on the photomask 130 is 1/(N²) relative to energy of laser light 5 necessary for peeling the object to be transferred 75 from the first substrate 70A. Accordingly, degradation of the shaping optical system 120 and the photomask 130 caused by laser irradiation can be prevented, and thermal drift caused by energy of laser light 3 can be prevented, and thus thermal expansion of the photomask 130 can be suppressed, and high-accuracy transfer can be performed even after laser lift-off for a long time. Moreover, degradation of the photomask 130 can be suppressed to extend lifetime. In addition, the thickness of a light-shielding material of the photomask can be reduced to, for example, 1000 Angstrom or less.

The alignment camera 170 and the controller 300 are configured to monitor a laser irradiation region on the first substrate 70A and control the laser device 110, the photomask 130, and the stage 160 (the upper stage 161 and the lower stage 162). The controller 300 can change the position of the pattern of the photomask 130 with respect to the optical path of laser light 3 by moving the photomask 130, for example. The controller 300 can also change the position of the first substrate 70A, particularly the position of the object to be transferred 75, with respect to the optical path of laser light 5 by moving and/or rotating the upper stage 161 on the same plane. The controller 300 can also change the position of the second substrate 70B with respect to the optical path of laser light 5 by moving and/or rotating the lower stage 162 on the same plane.

In the laser lift-off apparatus 100B illustrated in FIG. 9, the laser device 110, the photomask 130, the alignment camera 170, the upper stage 161, and the lower stage 162 are each electrically connected to the controller 300.

The controller 300 can control the laser lift-off apparatus 100B to perform a laser lift-off method of the present invention as described later.

The transfer apparatus 100B of the present invention is not limited to an apparatus that performs Gap-LLO as illustrated in FIG. 9, and may be an apparatus that performs Contact-LLO.

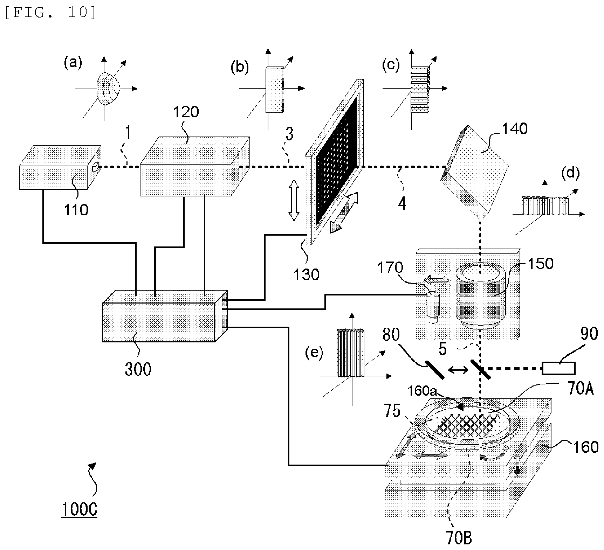

FIG. 10 is a schematic diagram of a second embodiment of the transfer apparatus of the present invention. A transfer apparatus 100C illustrated in FIG. 10 is an apparatus configured to perform Contact-LLO. The transfer apparatus 100C illustrated in FIG. 10 is identical to the transfer apparatus 100B illustrated in FIG. 9 except that the substrate stage 160 having an opening portion 160a supports the first substrate 70A and the second substrate 70B in a state in which the object to be transferred 75 on the first substrate 70A is in contact with the second substrate 70B.

### [Transfer Method]

The transfer method of the present invention is a transfer method for transferring an object to be transferred provided on a substrate to another substrate by irradiating the object to be transferred with laser light through the substrate, by the laser processing method of the present invention. The transfer method of the present invention can be performed by using the transfer apparatus 100B illustrated in FIG. 9, but is not limited thereto, and can be performed by using the transfer apparatus 100C illustrated in FIG. 10 or another apparatus.

According to the transfer method of the present invention, when transfer of an object to be transferred is not performed, the shutter 80 is closed and laser light can be maintained in a state of having reached the reduced projection optical system 150, and thus the temperature of the reduced projection optical system 150 can be maintained at the same temperature as that during transfer of the object to be transferred. Since the influence of dimensional change of the reduced projection optical system 150 caused by temperature change of the reduced projection optical system 150 can be suppressed, transfer of the object to be transferred can be resumed only by removing the shutter from the optical path, a decrease in throughput of transfer of the object to be transferred can be suppressed, and the object to be transferred can be transferred reliably and in a positionally stable state without causing defects such as breakage or cracking.

Hereinafter, as an embodiment of the transfer method of the present invention, an example of the transfer method of the present invention that can be performed by using the transfer apparatus 100B illustrated in FIG. 9 will be specifically described.

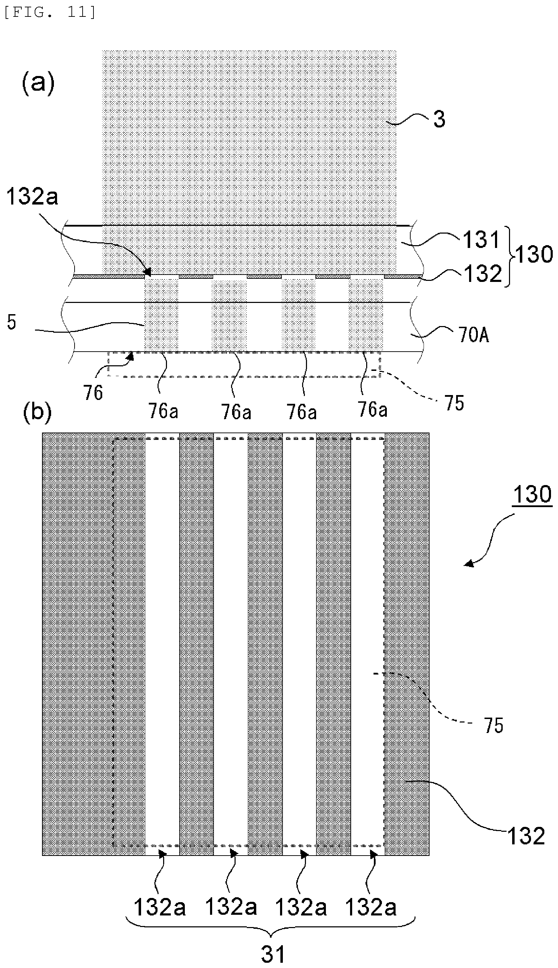

The transfer method of the present invention includes a batch transfer process by partial irradiation, which is described below with reference to FIG. 11.

FIG. 11(a) is a schematic sectional view illustrating a concept of laser irradiation in the batch transfer process in an example of the transfer method of the present invention. FIG. 11(b) is a diagram illustrating the positional relation between the pattern of the photomask and one object to be transferred during the laser irradiation illustrated in FIG. 11(a).

In this example, laser light 1 oscillated from the laser device (laser oscillator) 110 illustrated in FIG. 9 is shaped into laser light 3 by the shaping optical system 120. Laser light 3 is incident on the photomask 130 illustrated in FIGS. 11(a) and 11(b).

The photomask 130 illustrated in FIGS. 11(a) and 11(b) includes a laser-transmissive base material 131, and a patterning layer 132 formed on the base material 131. As illustrated in FIG. 11(b), a pattern 31 including a plurality of opening portions 132a is formed in the patterning layer 132.

Since a portion of the patterning layer 132 other than the opening portions 132a shields laser light, only components of laser light 3 incident on the photomask 130 that have passed through portions corresponding to the opening portions 132a pass through the photomask 130. As a result, laser light (laser light 4 illustrated in FIG. 9) having an irradiation shape with the pattern 31 is emitted from the photomask 130. Subsequently, although not illustrated in FIG. 11, laser light 4 is incident on the reduced projection optical system 150 illustrated in FIG. 9. In the reduced projection optical system 150, laser light 4 is reduced while maintaining the pattern 31 illustrated in FIG. 11(b) as an irradiation shape, and is emitted as laser light 5.

Laser light 5 emitted from the reduced projection optical system 150 is incident on a surface of the first substrate 70A opposite to the object to be transferred 75 when the shutter 80 is opened. Laser light 5 passes through the first substrate 70A and reaches an interface 76 between the first substrate 70A and the object to be transferred 75.

The interface does not mean a strict boundary surface, but means a region that is decomposed or otherwise affected by laser irradiation. Thus, the interface can also be rephrased as an ablation layer. Specifically, examples include an aspect in which at least part of a side of the first substrate 70A provided with the object to be transferred 75 is an ablation layer, an aspect in which an ablation layer is formed on the side of the first substrate 70A provided with the object to be transferred 75, an aspect in which at least part of the first substrate 70A side of the object to be transferred 75 is an ablation layer, an aspect in which an ablation layer is formed on the first substrate 70A side of the object to be transferred 75, and an aspect in which an ablation layer is located between the first substrate 70A and the object to be transferred 75, and a portion of the first substrate 70A or the object to be transferred 75 may be an ablation layer, or an ablation layer may be provided separately from the first substrate 70A and the object to be transferred 75.

Note that, although only one object to be transferred 75 is illustrated in FIG. 11, in the transfer method of the present embodiment, laser light 5 is collectively emitted to the interfaces 76 between the plurality of objects to be transferred 75 and the first substrate 70A in the batch transfer process. However, the plurality of objects to be transferred 75 do not necessarily need to be adjacent to each other, and may be, for example, a plurality of objects to be transferred 75 arranged away from each other without being adjacent to each other.

As described above, laser light 5 has an irradiation shape with the pattern 31 of the photomask 130. Thus, as illustrated in FIGS. 11(a) and 11(b), laser light 5 is emitted not to the entire interface 76 between each of the plurality of objects to be transferred 75 and the first substrate 70A but only to a portion 76a. Thus, in the laser lift-off method of the present invention, laser light 5 is emitted only to the portion 76a of the interface 76 between each of the plurality of objects to be transferred 75 and the first substrate 70A in the batch transfer process (partial irradiation).

In the batch transfer process, the plurality of objects to be transferred 75 are peeled from the first substrate 70A by partially irradiating the plurality of objects to be transferred 75 with laser light 5 in this manner.

Energy necessary for peeling is energy with which a bonding force (for example, an adhesive force or a joining force) between the object to be transferred 75 and the first substrate 70A can be weakened to separate the object to be transferred 75 and the first substrate 70A. For example, when a GaN layer is present at the interface between the object to be transferred 75 and the first substrate 70A, the GaN layer needs to be decomposed (ablated) in order to peel the object to be transferred 75. Laser energy density necessary in this case is high. Furthermore, nitrogen gas is generated by decomposition of the GaN layer. With pressure of the generated nitrogen gas acting as a propulsive force, the object to be transferred 75 peeled from the first substrate 70A moves to the second substrate 70B. Accordingly, transfer is achieved.

Although GaN is difficult to decompose, GaN is rapidly decomposed when an energy threshold is exceeded. Thus, in the batch transfer process, when the entire interface 76 between each of the plurality of objects to be transferred 75 and the first substrate 70A is irradiated with laser light at energy with which peeling between the object to be transferred 75 and the first substrate 70A can be achieved, a large amount of nitrogen gas is rapidly generated, and an ejection vector caused by the generated gas becomes excessively large. Accordingly, the object to be transferred 75 peeled from the first substrate 70A receives excessive pressure or has an excessively high initial velocity, and collides with a surface of the second substrate 70B with an extremely large ejection force from the first substrate 70A to the second substrate 70B. As a result, the object to be transferred 75 is likely to break during movement from the first substrate 70A to the second substrate 70B, or breakage or partial loss is likely to occur in the object to be transferred 75 when the object to be transferred 75 reaches the second substrate 70B. In addition, due to the excessive ejection vector, movement of the object to be transferred 75 to the second substrate 70B becomes difficult to control, and unintended positional displacement is likely to occur when the object to be transferred 75 is transferred to the second substrate 70B.

In contrast, in the transfer method of the present invention, since only part of the interface 76 is partially irradiated with laser light 5 for the plurality of objects to be transferred 75 in the batch transfer process as described above, the amount of gas generated when the plurality of objects to be transferred 75 are peeled from the first substrate 70A is reduced, and pressure received by the object to be transferred 75 peeled from the first substrate 70A can be reduced. As a result, a propulsive force applied to the object to be transferred 75 peeled from the first substrate 70A is moderately suppressed, and impact caused by contact between an object to be transferred 1 and the second substrate 70B can be reduced. In addition, the peeled object to be transferred 75 can be moved straight from the first substrate 70A to the second substrate 70B, and a lift-off process with high transfer positional accuracy can be realized.

In the above, a case where the GaN layer is decomposed during peeling is described as an example, but since peeling caused by laser lift-off is based on ablation, a problem that the ejection vector becomes excessively large as described above inevitably occurs in a case of entire-surface irradiation. On the other hand, in the laser lift-off method of the present embodiment, since partial irradiation is performed in the batch transfer process, the ejection vector can be kept small, and thus transfer of the object to be transferred 75 can be performed while damage such as breakage or partial loss of the object to be transferred 75 is prevented, regardless of combination of the first substrate 70A and the object to be transferred 75. In addition, application of partial irradiation to laser lift-off using ablation has been described here, but even in a transfer method that does not use ablation but applies a propulsive force to an object to be transferred by laser irradiation, partial irradiation with laser light can reduce the propulsive force, which can lead to improvement in transfer accuracy.

Furthermore, even in transfer by the Contact-LLO method using the transfer apparatus 100C illustrated in FIG. 10, for example, breakage or partial loss may occur due to the ejection vector becoming excessively large in the case of entire-surface irradiation as described above. According to the transfer method of the present invention, even with the Contact-LLO method, transfer of the object to be transferred 75 can be performed while damage such as breakage or partial loss of the object to be transferred 75 is prevented.

When a decomposition product is generated by laser irradiation, the amount of the generated product can be reduced, and a subsequent cleaning process can be simplified.

### [Object to be Transferred]

An object to be transferred in the transfer method of the present invention is not particularly limited. For example, an object selected from the group consisting of a semiconductor chip, an LED chip, a resin material film, and an inorganic film may be transferred as the object to be transferred. The resin material film may contain an inorganic material in the film. Furthermore, the resin material film may have a multi-layer structure, and a plurality of films constituting the multi-layer structure may include only resin material films or may include a combination of a resin material film and an inorganic material film.

When an object to be transferred having a small thickness of 1 to 10 µm is subject to entire-surface irradiation by a normal laser lift-off method, the object to be transferred is likely to be damaged during laser lift-off as the longitudinal dimension of the object to be transferred or the area of the object to be transferred increases. Specifically, in the case of an object to be transferred having a longitudinal dimension of 80 µm or more or an object to be transferred having an area of 6400 µm² or more, the object to be transferred is likely to break during laser lift-off by entire-surface irradiation, and thus application of the present invention, which can reduce a propulsive force applied to the object to be transferred, is effective. Although the upper limit of the longitudinal dimension and the upper limit of the area are not particularly limited, the upper limits are 500 µm or less and 40000 µm² or less approximately from the viewpoint of ease of production. Needless to say, in the present invention, a method for performing laser lift-off by collectively irradiating the entire surface of the object to be transferred with laser light may be used instead of an irradiation method by partial irradiation.

As described above in detail, according to the laser processing apparatus of the present invention, since irradiation is performed on the reduced projection optical system, the temperature of the reduced projection optical system can be maintained at the same temperature as that during laser processing of a body to be processed, the influence of dimensional change of the reduced projection optical system caused by temperature change can be suppressed, and a decrease in throughput of the laser processing can be suppressed. In addition, according to the laser machining apparatus of the present invention, a decrease in throughput of laser machining can be suppressed. Moreover, the shape and the position of laser irradiation can be stabilized, and thus stable machining processing can always be performed regardless of the interval of laser machining.

According to the transfer apparatus of the present invention, a decrease in throughput of transfer of the object to be transferred by laser irradiation can be suppressed. In addition, according to the laser processing method of the present invention, the reduced projection optical system is irradiated with laser light even while the laser light path is blocked by the shutter, and thus the temperature of the reduced projection optical system can be maintained at the same temperature as that during laser processing of a body to be processed, the influence of dimensional change of the reduced projection optical system caused by temperature change can be suppressed, a decrease in throughput of the laser processing can be suppressed, and the object to be transferred can be transferred reliably and in a positionally stable state without causing defects such as breakage or cracking.

According to the laser machining method of the present invention, a decrease in throughput of laser machining can be suppressed. Moreover, the shape and the position of laser irradiation can be stabilized, and thus stable machining processing can always be performed regardless of the interval of laser machining. In addition, according to the transfer method of the present invention, a decrease in throughput of transfer of the object to be transferred by laser irradiation can be suppressed, and the object to be transferred can be transferred reliably and in a positionally stable state without causing defects such as breakage or cracking.

The present description includes the following embodiments.
[1] A laser processing apparatus for performing laser processing by irradiating a substrate arranged on a substrate stage with laser light, the laser processing apparatus comprising:
   a laser device that oscillates the laser light;
   a reduced projection optical system; and the substrate stage,
   wherein the laser processing apparatus includes a shutter between the reduced projection optical system and the substrate stage.
[2] The laser processing apparatus of the above [1], wherein the shutter is a shutter comprising an optical path changing member that forms an inclined surface with respect to an optical axis of the laser light and is capable of being arranged on the optical axis of the laser light and being removed from the optical axis of the laser light.
[3] The laser processing apparatus of the above [1] or [2], further comprising a damper that, when the shutter blocks an optical axis of the laser light to switch the optical path of the laser light, absorbs energy of the laser light on the switched optical path.
[4] A laser machining apparatus including the laser processing apparatus of any one of the above [1] to [3], wherein the laser machining apparatus performs shape machining on a surface of the substrate by irradiating the substrate with the laser light.
[5] A transfer apparatus including the laser processing apparatus of any one of the above [1] to [3], wherein the transfer apparatus transfers an object to be transferred provided on the substrate to another substrate by irradiating the object to be transferred with the laser light through the substrate.
[6] A laser processing method for performing laser processing by irradiating a substrate arranged on a substrate stage with laser light by using a laser processing apparatus including a laser device that oscillates the laser light, a reduced projection optical system, the substrate stage, and a shutter between the reduced projection optical system and the substrate stage,
   wherein when the substrate is not irradiated with the laser light, the shutter is closed while the laser light is being oscillated.
[7] The laser processing method of the above [6], wherein, as the shutter, a shutter is used that comprises an optical path changing member that forms an inclined surface with respect to an optical axis of the laser light and is capable of being arranged on the optical axis of the laser light and being removed from the optical axis of the laser light.
[8] The laser processing method of the above [6] or [7], wherein an optical path of the laser light is switched by closing the shutter, and energy of the laser light is absorbed by a damper arranged on the switched optical path of the laser light.
[9] A laser machining method for performing shape machining on a surface of the substrate as the laser processing by using the laser processing method of any one of the above [6] to [8].
[10] A transfer method for transferring an object to be transferred provided on a substrate to another substrate by irradiating the object to be transferred with the laser light through the substrate, by using the laser processing method of any one of the above [6] to [8].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A laser processing apparatus for performing laser processing by irradiating a substrate arranged on a substrate stage with laser light, the laser processing apparatus comprising:
a laser device that oscillates the laser light;
a reduced projection optical system; and
the substrate stage,
wherein the laser processing apparatus includes a shutter between the reduced projection optical system and the substrate stage.

2. The laser processing apparatus according to claim 1, wherein the shutter is a shutter comprising an optical path changing member that forms an inclined surface with respect to an optical axis of the laser light and is capable of being arranged on the optical axis of the laser light and being removed from the optical axis of the laser light.

3. The laser processing apparatus according to claim 1, further comprising a damper that, when the shutter blocks an optical axis of the laser light to switch the optical path of the laser light, absorbs energy of the laser light on the switched optical path.

4. A laser machining apparatus including the laser processing apparatus according to any one of claims 1 to 3, wherein the laser machining apparatus performs shape machining on a surface of the substrate by irradiating the substrate with the laser light.

5. A transfer apparatus including the laser processing apparatus according to any one of claims 1 to 3, wherein the transfer apparatus transfers an object to be transferred provided on the substrate to another substrate by irradiating the object to be transferred with the laser light through the substrate.

6. A laser processing method for performing laser processing by irradiating a substrate arranged on a substrate stage with laser light by using a laser processing apparatus including a laser device that oscillates the laser light, a reduced projection optical system, the substrate stage, and a shutter between the reduced projection optical system and the substrate stage,
wherein when the substrate is not irradiated with the laser light, the shutter is closed while the laser light is being oscillated.

7. The laser processing method according to claim 6, wherein, as the shutter, a shutter is used that comprises an optical path changing member that forms an inclined surface with respect to an optical axis of the laser light and is capable of being arranged on the optical axis of the laser light and being removed from the optical axis of the laser light.

8. The laser processing method according to claim 6, wherein an optical path of the laser light is switched by closing the shutter, and energy of the laser light is absorbed by a damper arranged on the switched optical path of the laser light.

9. A laser machining method for performing shape machining on a surface of the substrate as the laser processing by using the laser processing method according to any one of claims 6 to 8.

10. A transfer method for transferring an object to be transferred provided on a substrate to another substrate by irradiating the object to be transferred with the laser light through the substrate, by using the laser processing method according to any one of claims 6 to 8.
